# EUROPEAN PATENT APPLICATION

(11) **EP 4 293 598 A1**
(43) Date of publication of application: **20.12.2023**
(21) Application number: 22210162.8
(22) Date of filing: 29.11.2022
(51) Int. Cl.: G06Q 30/0601, G06Q 50/08

(54) **METHOD AND DEVICE FOR INTELLIGENT CONSTRUCTION**

(30) Priority: 14.06.2022 CN 202210672585
(71) Applicant: Northwest Instrument Inc., Dover, NJ 07801 (US)
(72) Inventor: HUANG, Wei, Suzhou, Jiangsu, 215345 (CN); XING, David, Dover, New Jersey, 07801 (US)
(74) Representative: Isarpatent

(57) **Abstract**

An intelligent construction method includes obtaining dimensional data of a construction object from a ranging device and obtaining a construction request of the construction object confirmed by a user. The construction request includes the dimensional data and a construction requirement. The method further includes determining construction information corresponding to the construction request, determining a construction solution of the construction object based on the construction information, and obtaining a construction list of the construction object generated based on the construction solution.

## Description

### TECHNICAL FIELD

The present disclosure relates to the smart technology field and, more particularly, to a method and a device for intelligent construction.

### BACKGROUND

In the current construction and remolding fields, measurement is performed on a to-be-constructed actual scene (i.e., a construction object) first. Then, based on dimensional data of the actual scene, materials are selected and purchased in a large shopping mall or market, and construction crews are hired to perform the construction. That is, measurement, design, purchase, and building construction are all independent from each other. Thus, an entire building design and construction process are low efficient.

In addition, when the construction is performed according to drawings, a positioning target point needs to be determined by a traditional measurement tool for a plurality of measurements, which also makes the construction performed according to the drawings in the traditional method time-consuming, work-intensive, and labor-intensive. Thus, the cost of the entire process is increased.

In summary, in the existing technology, there are deficiencies or inconveniences in the measurement, design, material selection, and construction. For example, at least the following deficiencies are included.

First, in the current surveying and mapping, design and execution are separated. That is, virtual and reality are independent of each other. Key data needs to be transmitted manually.

Second, in the current surveying and mapping, a positioning manner is cumbersome and time-consuming.

Third, when laying or decoration is performed on an irregular construction object, an area can only be calculated by measuring an approximate shape, and material consumption is estimated by experience.

### SUMMARY

In response to the above problems, a first aspect of the present disclosure proposes an intelligent construction method, the intelligent construction method includes: obtaining dimensional data of a construction object from a ranging device; obtaining a construction request of the construction object confirmed by a user, the construction request including the dimensional data and a construction requirement; determining construction information corresponding to the construction request; determining a construction solution of the construction object based on the construction information; and obtaining a construction list of the construction object generated based on the construction solution.

The intelligent construction method disclosed in the first aspect of the present disclosure intelligently provides construction information and the corresponding construction solution according to the construction request confirmed by the user, thereby providing the user with a perfect construction solution, avoiding excessive construction loss, accelerating the construction progress and improving the user's experience and satisfaction.

In response to the above problems, a second aspect of the present disclosure proposes an intelligent construction device, including a memory and a processor. The memory stores a program. The processor is coupled with the memory and, when the program is executed, configured to obtain dimensional data of a construction object from a ranging device and obtain a construction request of the construction object confirmed by a user. The construction request includes the dimensional data and a construction requirement. The processor is further configured to determine construction information corresponding to the construction request, determine a construction solution of the construction object based on the construction information, and obtain a construction list of the construction object generated based on the construction solution.

The intelligent construction device disclosed in the second aspect of this disclosure enables the user to realize intelligent construction using the device, ranging device, etc. to quickly complete the construction design plan, speed up the construction progress and reduce construction losses.

### BRIEF DESCRIPTION OF THE DRAWINGS

FIG. 1 is a schematic flowchart of a method for intelligent construction according to embodiments of the present disclosure.
FIG. 2 is a schematic flowchart of another method for intelligent construction according to embodiments of the present disclosure.
FIG. 3 is a schematic diagram of a device for intelligent construction according to embodiments of the present disclosure.

### DETAILED DESCRIPTION OF THE EMBODIMENTS

The technical solutions of the present disclosure are further described in detail through embodiments of the present disclosure and in connection with the accompanying drawings. In the specification, a same or similar reference numeral may refer to a same or similar component. The following description of embodiments of the present disclosure with reference to the accompanying drawings is intended to explain a general concept of the present disclosure, and should not be considered as a limitation of the present disclosure.

The terms "including," "comprising," and a similar term used herein should be understood as open-ended terms, that is "including/comprising but not limited to," which indicates that other contents may also be included. The term "based on" means "at least partially based on." The term "one embodiment" means "at least one embodiment." The term "another embodiment" means "at least one additional embodiment."

Embodiments of the present disclosure mainly focus on the following technical problems of how to realize intelligent construction for a construction object, improve construction efficiency, and purchase corresponding products by placing an order with one click.

In order to solve the above-mentioned problems, a method for intelligent construction of the present disclosure includes obtaining dimensional data of the construction object from a ranging device, obtaining a construction request of the construction object confirmed by a user, the construction request including the dimensional data and construction requirements, determining construction information corresponding to the construction request, determining a construction solution of the construction object based on the construction information, and obtaining a construction list of the construction object generated based on the construction solution.

### Embodiment 1

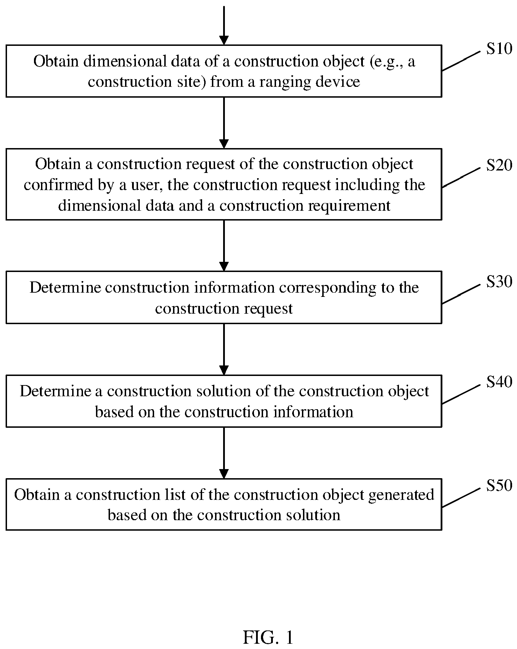

In some embodiments, the intelligent construction of the construction object is realized by the method shown in Figure 1.

At S10, dimensional data of the construction object (e.g., a construction site) is obtained from the ranging device.

In some embodiments, a ranging wheel may be used as a ranging device. The dimensional data of the construction object may be obtained by pushing the ranging wheel in an outline measurement manner. The dimensional data may include, for example, data such as sizes and areas of the construction object along various directions to be constructed. In the present disclosure, the ranging device may not be limited to the ranging wheel. Another ranging device, such as a smart tape measure, may be used as the ranging device. The ranging device of the present disclosure may be configured to transmit the measured dimensional data to an APP (software application) with an intelligent construction method through wireless transmission or wired transmission. For example, the dimensional data may be transmitted to the APP through USB, Bluetooth, or WiFi.

Further, the software in the APP may be configured to generate the construction drawings of the construction object according to the dimensional data. In the APP of the present disclosure, an external link may be added. A third-party website may be connected via an external link. The dimensional data may be sent to the third party via the external link. The third-party may provide implementable construction drawings according to the dimensional data.

At S20, a construction request of the construction object confirmed by the user is obtained. The construction request includes the dimensional data and the construction requirements.

In the present embodiment, the construction requirement may include a specific requirement for the construction object. For example, if the construction object is to pave a road, the dimensional data may include a width and a length of a road surface and a thickness of the road, and the construction requirement may include, a pavement material (e.g., anti-skid material, cement, etc.) of the road surface. If the construction object is to build a swimming pool, the dimensional data may include data such as a length, a width, and a height of the swimming pool. The construction requirement may include a material in the swimming pool and a color of the material. The construction requirement may further include user personal preference information (e.g., budget requirement, construction period, etc.). In the present disclosure, the user may directly confirm the construction requirements on the APP.

At S30, the construction information corresponding to the construction request is confirmed.

In particular, the APP of the present disclosure may include a database that stores various construction information. The user may screen the construction information corresponding to the construction request from the database. The third party that communicates with the APP may receive the construction request through the APP and send the corresponding construction information to the user through the APP for confirmation.

In the present embodiment, the APP may provide the corresponding construction information according to the construction request. The construction information may include one or more recommended solutions and one or more pieces of material information.

In particular, each recommended solution may include a combination of one or more material types and parameter information corresponding to the one or more material types provided to realize the construction requirement.

In the present embodiment, the parameter information of each material type may include a material attribute and a material unit price of the material.

For example, in the present embodiment, according to the dimensional data, the construction drawings, and/or the user personal preference information, a variety of materials (e.g., cement, tile, wood, etc.) and the parameter information of each material (e.g., a type of the tile (e.g., solid, glazed, polished, etc.), tile color, tile size, unit price, etc.) may be matched to the construction object.

In particular, recommended solution A may include a combination of cement a, ceramic tile b, and wood c. Recommended solution B may include a combination of cement b, ceramic tile a, and wood e. Recommended solution C may include cement c, ceramic tile f, and wood a.

Meanwhile, each material information may include a material type, a material name determined based on the material type and the dimensional data, a material usage amount for the construction object, a total material price, and supplier information.

For example, according to the dimensional data, construction drawings, and/or user personal preference information, the material information of the related material (e.g., tile: glazed tile, xx pieces, total yy yuan, and supplier A).

At S40, the construction solution of the construction object is confirmed based on the construction information.

In the present step, when the user is satisfied with any recommended solution provided by the APP or the third party that communicates with the APP, the user may confirm the selected recommended solution of the one or more recommended solutions can be confirmed as the construction solution.

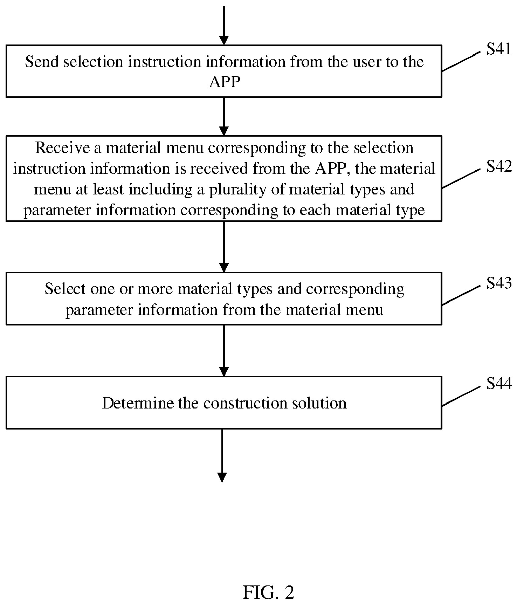

Alternatively, when the user does not agree with all the recommended solutions provided by the APP, with reference to FIG. 2, step S40 further includes the following steps.

At S41, selection instruction information from the user is sent to the APP.

At S42, a material menu corresponding to the selection instruction information is received from the APP. The material menu at least includes a plurality of material types and parameter information corresponding to each material type.

The APP may be configured to generate a corresponding material menu according to the selection instruction information and send the material menu.

At S43, one or more material types and corresponding parameter information are selected from the material menu.

At S44, the construction solution is confirmed.

In the APP of the present disclosure, various construction requirements and construction information may be stored. The user may input the construction requirements in the selection menu of the APP. The APP may pop up the material menu corresponding to the construction requirements. The user may select the corresponding material type and the parameter information corresponding to each material type in the material menu as needed. After the user confirmed the material type and the parameter information corresponding to each material type, the construction information may be generated.

At S50, a construction list of the construction object generated based on the construction solution is obtained.

In the present embodiment, the APP may be configured to generate the corresponding construction list according to the construction solution.

The construction list may at least include all material types related to the construction solution, an amount of the material that is used, a unit price, and a total price of each type of material.

In addition, in some embodiments, the method may include the following steps.

A purchase order may be sent to the APP based on the construction list. The purchase order may be used to pay the fee shown in the construction list.

Thus, in the present embodiment of the present disclosure, the ranging device may establish the communication with the APP to transmit the dimensional data, automatically obtain the construction information from the APP, and obtain the construction list with one-click of the construction object. The problem of time-consuming and low efficiency caused by the need to self-search for the materials and self-design the construction object in the actual construction process may be avoided. The problem of excessive purchase of the construction materials due to incorrect dimensional data of the construction object may be further avoided.

### Embodiment 2

In the present embodiment, in the method shown in FIG. 1, the intelligent construction of the construction object may also be realized.

At S10, the dimensional data of the construction object (e.g., the construction site) is obtained from the ranging device. Step S10 is similar to S10 in the above embodiments, which is not repeated here.

At S20, the construction request of the construction object confirmed by the user is obtained. The construction request includes the dimensional data and the construction requirement.

In the present embodiment, the construction requirement may include at least construction style information and user personal preference information (e.g., a budget requirement, a construction period, etc.).

In the present embodiment, the construction style information may include one or more reference pictures, reference videos, and style descriptions (e.g., modern simplest style, Chinese style, light luxury style, European and American style, Japanese style, etc.). For example, the user may select a picture or a video that needs to be referenced as a construction requirement from a construction style menu of the APP. In the APP, the construction information corresponding to the reference picture or the reference video may be stored.

At S30, the construction information corresponding to the construction request is confirmed.

Step S30 may be similar to S10 of the embodiment 1. A difference between step S30 in this embodiment and S10 in the embodiment 1 may include that each recommended solution may include one or more material types and a combination of the parameter information corresponding to the one or more material types provided to realize the construction requirements. The parameter information of each material type may include the attribute and the unit price of the material.

For example, in the present embodiment, a variety of materials (e.g., cement, tile, wood, etc.) and the parameter information (e.g., the type of tile (e.g., solid tile, glazed tile, polished tile, etc.), tile color, tile size, unit price, etc.) of each material may be selected for the construction object according to the dimensional data, the construction drawings, the construction style information, and/or the user personal preference information.

For example, based on the dimensional data, the construction drawings, the modern simplest style, the total budget xxx yuan, and estimated time of tt months, recommended solution A may include a combination of cement a, ceramic tile b, and wood c, recommended solution B may include a combination of cement b, ceramic tile a, and wood e, and recommended solution C may include a combination of cement c, ceramic tile f, and wood a.

Meanwhile, each material information may include a material type, a material name determined based on the material type and the dimensional data, a material usage amount for the construction object, a total material price, and supplier information.

For example, based on the dimensional data, the construction drawings, the construction style information, and/or the user personal preference information, the material information of the related material (e.g., ceramic tile: glazed tile, xx pieces, total price yy yuan, supplier A) may be provided.

At S40, the construction solution of the construction object is confirmed based on the construction information. Step S40 is similar to S40 of the above embodiments, which is not repeated here.

At S50, the construction list of the construction object generated based on the construction solution is obtained. Step S50 is similar to S50 of the above embodiments, which is not repeated here.

Thus, in embodiments of the present disclosure, the intelligent construction similar to the intelligent construction of the above embodiments may be realized. Accurate measurement, accurate quotation, and a corresponding construction service obtained through one-click purchase and payment may be realized.

### Embodiment 3

In the present embodiment, the intelligent construction of the construction object may be realized using the method shown in FIG. 1 in a slightly different manner from the implementations of the above embodiments 1 and 2.

At S 10, obtain the dimensional data of the construction object from the ranging device. Step S10 is similar to S10 of the above embodiments and is not repeated here.

In the present embodiment, between steps S10 and S20, the method may further include the following steps.

One or more pieces of construction style information corresponding to the construction request may be received. One of the pieces of the construction style information may be selected. That is, in some embodiments, the construction style information suitable for the construction object may be provided by the third party or the APP.

The construction style information of embodiments of the present disclosure is similar to the construction style information of the above embodiment 2.

At S20, the construction request of the construction object confirmed by the user is obtained. The construction request includes the dimensional data and the construction requirement.

In the present embodiment, the construction requirement is similar to the construction requirement of the above embodiments and also includes the construction style information selected by the user.

At S30, the construction information corresponding to the construction request is confirmed.

In the present embodiment, the APP may provide the corresponding construction information according to the construction request. The construction information may include one or more recommended solutions and one or more pieces of material information. Then, the construction information may be received and confirmed.

In particular, each recommended solution may include one or more material types corresponding to the construction style information selected by the user and a combination of parameter information corresponding to each material type, which is similar to the above embodiments.

For example, in the present embodiment, based on the dimensional data, the construction drawings, the construction style information, and/or the user personal preference information, a plurality of materials and the parameter information (e.g., the type of the tile (e.g., solid tile, glazed tile, polished tile, etc.), tile color, tile size, unit price, etc.) of each material may be selected for the construction object.

Meanwhile, each material information is similar to the above embodiments and is not repeated here.

At S40, the construction solution of the construction object is confirmed based on the construction information.

At S50, the construction list of the construction object generated based on the construction solution is obtained. In some embodiments, the construction list corresponding to the construction solution is received.

Steps S40 and S50 of the present embodiment are similar to the related steps of the above embodiments and are not repeated here.

In addition, in the present embodiment, the method may further include the following steps after step S50.

A completed rendered drawing corresponding to the construction solution is received. The completed rendered drawing is formed based on the construction solution.

Thus, the user may confirm whether the requirements are satisfied according to the completed rendered drawing. If the requirements are not satisfied, steps S20 to S50 may be re-performed to ensure that the obtained construction solution and the construction list meet the expectation. If the requirements are satisfied, the following steps may be performed.

A purchase order is sent to the APP based on the construction list. The purchase order is used to pay the fee shown on the construction list.

In the method for the intelligent construction of embodiments of the present disclosure, the construction list may be quickly and conveniently obtained using the construction requirement and the dimensional data generated by the ranging device to realize the intelligent construction of the construction object.

### Embodiment 4

In the present embodiment, the intelligent construction of the construction object may be realized by using the method shown in FIG. 1 with a slightly different manner from the implementations of the above embodiments

Steps S10, S20, and the related steps are similar to the above embodiments and are not repeated here.

At S30, the construction information corresponding to the construction request is confirmed.

The construction information of the present embodiment may include, in addition to the contents described in the above embodiments 1-3, a labor quantity, construction time, and labor cost required to complete the construction object.

In the present embodiment, the APP may provide the corresponding construction information according to the construction request. The construction information may include one or more recommended solutions and one or more pieces of material information.

Thus, in order to realize the construction requirement, each recommended solution may include one or more material types and a combination of the parameter information corresponding to each material type and construction firm information.

For example, recommended solution A may include a combination of cement a, ceramic tile b, wood c, and construction firm a. Recommended solution B may include a combination of cement b, ceramic tile a, wood e, and construction firm b. Recommended solution C may include a combination of cement c, ceramic tile f, wood a, and construction firm c.

At S40, the construction solution of the construction object is confirmed according to the construction information. Step S40 is similar to S40 of the above embodiments and is not repeated here.

At S50, the construction list of the construction object generated based on the construction solution is obtained.

In the present embodiment, the construction list may at least include material types relevant to the construction solution, a material used amount of each material type, a material unit price, a total material cost, construction firm information, a labor quantity, construction time, and labor cost.

In addition, the method of embodiments of the present disclosure may further include the following step after step S50.

The completed rendered drawing corresponding to the construction solution may be received. The completed rendered drawing may be formed based on the construction solution.

Thus, the user may determine whether the requirements are satisfied according to the completed rendered drawing. If the requirements are not satisfied, steps S20 to S50 may be re-performed to ensure that the obtained construction solution and the construction list satisfy the expectations. If the requirements are satisfied, the following step may be performed.

The purchase order may be sent to the APP based on the construction list. The purchase order may be used to pay the fee shown on the construction list.

In the method for the intelligent construction of embodiments of the present disclosure, effects of the above embodiments may be realized. The construction service may be provided to the user with satisfaction using the dimensional data generated by the ranging device and the construction requirement. The construction list provided by the APP may be quickly and conveniently obtained. The intelligent construction of the construction object may be realized.

### Embodiment 5

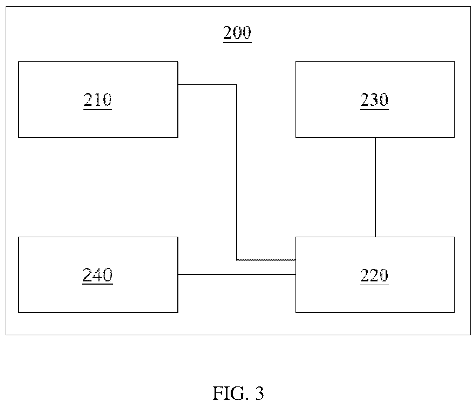

In the present embodiment, the method for the intelligent construction of embodiments 1-4 of the present disclosure may be implemented by an intelligent construction device shown in FIG. 3.

The device of embodiments of the present disclosure includes a first information acquisition module 210, an information representation module 230, a second information acquisition module 240, and an information confirmation module 220. A specific work principle of the intelligent construction device may be described as follows.

The first information acquisition module 210 may be configured to obtain the dimensional data of the construction object (e.g., the construction site) from the ranging device.

In the present embodiment, the ranging wheel may be used as the ranging device. The dimensional data of the construction object may be obtained by pushing the ranging wheel in the outline measurement manner. The ranging wheel may be configured to send the dimensional data to the first information acquisition module 210. The dimensional data, for example, may include data such as sizes and areas of the construction object along various directions to be constructed.

In addition, the first information acquisition module 210 may be configured to send the dimensional data to the information confirmation module 220.

The second information acquisition module 240 may be configured to obtain the construction request of the construction object confirmed by the user. In this example, the construction request may include the dimensional data and the construction requirement.

In the present embodiment, the information confirmation module 220 may be configured to generate the construction drawings of the construction object according to the dimensional data and generate the construction requirement based on the construction drawings (e.g., the user personal preference information (e.g., the budget requirement, the construction period, etc.) ) to generate the construction request and send the construction request to the user via the information presentation module 230.

Then, the user may send the confirmed construction request to the second information acquisition module 240.

Optionally, the construction requirement may further include the construction style information.

In some other embodiments, the information confirmation module 220 may be further configured to receive one or more pieces of construction style information corresponding to the construction request. The information confirmation module 220 may be further configured to select one construction style information of the one or more pieces of construction style information.

The information confirmation module 220 may be configured to receive the construction information corresponding to the construction request.

In the present embodiment, the APP may be configured to provide the corresponding construction information according to the construction request. The construction information may include one or more recommended solutions and one or more pieces of material information.

In particular, each recommended solution may include one or more material types and a combination of the parameter information corresponding to each material type. The parameter information of each material type may include the attribute and the unit price of the material.

Each piece of material information may include the material type, the material name determined based on the material type and the dimensional data, the material usage amount for the construction object, the total material price, and the supplier information.

In addition, in some embodiments, the construction information may include the labor quantity, the construction time, and the labor cost required to complete the construction object.

In the present embodiment, the information confirmation module 220 may be configured to confirm the construction solution of the construction object according to the construction information.

When the user is satisfied with any recommended solution provided by the APP or the third party, the user may confirm the selected recommended solution from the one or more recommended solutions through the information confirmation module 220 as the construction solution.

Alternatively, when the user does not agree with all the recommended solutions provided by the third party, the information confirmation module 220 may be configured to perform the following steps.

First, the selection instruction information from the user may be sent to the APP.

The user may select a plurality of materials for the construction object from the one or more pieces of material information in the construction information provided by the APP according to the user preference through the information confirmation module 220. In some other embodiments, the user may further select one or more materials, which are not provided in the construction information, to generate the selection instruction information. The selection instruction information may include the plurality of pieces of material information that are selected.

For example, the user may select a type of wood and a type of cement in the construction information and a type of tile not mentioned in the construction information to generate the selection instruction information.

Then, the material menu corresponding to the selection instruction information may be received from the APP. The material menu may at least include a plurality of material types and parameter information corresponding to each of the plurality of material types.

The APP may be configured to generate the corresponding material menu according to the selection instruction information and send the material menu.

Then, one or more material types and the corresponding parameter information may be selected from the material menu.

Then, the construction solution may be determined.

The information confirmation module 220 may be configured to confirm the construction information corresponding to the construction request and confirm the construction solution of the construction object based on the construction information.

The information presentation module 230 may be further configured to receive and represent the construction list corresponding to the construction solution.

In the present embodiment, the construction list may at least include the material types related to the construction solution, the material usage amount of each material type, the material unit price, and the total material price.

Then, the information presentation module 230 may be configured to receive the completed rendered drawing corresponding to the construction solution and display the completed rendered drawing through a display device. The completed rendered drawing may be formed based on the construction solution.

In the present embodiment, the user may determine whether the requirements are satisfied through the completed rendered drawing provided by the information presentation module 230. If the requirements are not satisfied, the device may further resend the construction request to ensure that the obtained construction solution and construction list satisfy the expectations.

When the user requirements are satisfied, the information confirmation module 220 may be configured to send the purchase order to the APP based on the construction list. The purchase order may be used to pay the fee shown on the construction list.

The intelligent construction device of embodiments of the present disclosure (e.g., a terminal apparatus such as a smartphone and a computer) may be configured to implement the methods for the intelligent construction of the above embodiments. The construction list may be quickly and conveniently obtained using the dimensional data generated by the ranging device and the construction requirement to realize the intelligent construction of the construction object. The accurate measurement, the accurate quotation, and the corresponding construction service obtained through the one-click purchase and payment may be realized. The intelligent construction device may include a memory and a processor. The memory may store a program that, when the program is executed, causes the processor to perform the intelligent construction method of embodiments of the present disclosure.

The above are some embodiments of the present disclosure, which are not intended to limit embodiments of the present disclosure. For those skilled in the art, various modifications and changes may be made to embodiments of the present disclosure. Any modifications, equivalent replacements, improvements, etc., made within the spirit and principles of embodiments of the present disclosure should be within the scope of embodiments of the present disclosure.

Although embodiments of the present disclosure have been described with reference to several specific embodiments, embodiments of the present disclosure are not limited to the disclosed specific embodiments. Embodiments of the present application are intended to cover various modifications and equivalent arrangements within the spirit and scope of the appended claims. The scope of the appended claims conforms to the broadest interpretation to include all such modifications and equivalent structures and functions.

## Claims

1. An intelligent construction method comprising:
obtaining (S10) dimensional data of a construction object from a ranging device;
obtaining (S20) a construction request of the construction object confirmed by a user, the construction request including the dimensional data and a construction requirement;
determining (S30) construction information corresponding to the construction request;
determining (S40) a construction solution of the construction object based on the construction information; and
obtaining (S50) a construction list of the construction object generated based on the construction solution.

2. The method according to claim 1, wherein the construction information further includes:
one or more recommended solutions, each recommended solution including one or more material types and a combination of parameter information corresponding to the one or more material types provided to realize the construction requirement; and
one or more pieces of material information, each piece of material information including a material type, a material name determined based on a material type and the dimensional data, a material usage amount for the construction object, a total material price, and supplier information.

3. The method according to claim 2, wherein the construction requirement includes construction style information.

4. The method according to claim 2, wherein determining the construction information corresponding to the construction request further includes:
obtaining the construction information corresponding to the construction request from a third party.

5. The method according to claim 4, further comprising, before obtaining the construction information corresponding to the construction request:
receiving, from the third party, one or more pieces of construction style information corresponding to the construction request; and
selecting one piece of construction style information from the one or more pieces of construction style information.

6. The method according to claim 4, wherein determining the construction solution of the construction object based on the construction information further includes:
sending user selection instruction information to the third party;
receiving a material menu corresponding to the selection instruction information from the third party, the material menu at least including a plurality of material types and parameter information corresponding to each material type;
selecting one or more material types and corresponding parameter information from the material menu; and
determining the construction solution.

7. The method according to claim 2, wherein determining the construction information corresponding to the construction request further includes:
obtaining the corresponding construction information from a database based on the construction request.

8. The method according to claim 7, further comprising, before obtaining the construction information corresponding to the construction request:
obtaining, from the database, one or more pieces of construction style information corresponding to the construction request; and
selecting one piece of construction style information from the one or more pieces of construction style information

9. The method according to claim 8, wherein determining the construction solution of the construction object based on the construction information further includes:
receiving selection instruction information from the user;
generating a material menu corresponding to the selection instruction information using the database, the material menu at least including a plurality of material types and parameter information corresponding to each material type;
selecting one or more material types and corresponding parameter information from the material menu; and
determining the construction solution.

10. The method according to claim 2, wherein the parameter information includes a material attribute and a material unit price.

11. The method according to claim 2, wherein determining the construction solution of the construction object based on the construction information further includes:
determining a selected recommended solution as the construction solution from the one or more recommended solutions.

12. The method according to claim 2, wherein the construction information includes a labor quantity, construction time, and labor cost required to complete the construction object.

13. The method according to claim 1, wherein the construction list at least includes material types related to the construction solution, a material usage amount of each material type, a material unit price, and a total material price.

14. The method according to claim 1, further comprising:
generating a purchase order based on the construction list, the purchase order being used to pay a fee on the construction list.

15. An intelligent construction device comprising:
a memory storing a program; and
a processor coupled with the memory and, when the program is executed, configured to:
obtain dimensional data of a construction object from a ranging device;
obtain a construction request of the construction object confirmed by a user, the construction request including the dimensional data and a construction requirement;
determine construction information corresponding to the construction request;
determine a construction solution of the construction object based on the construction information; and
obtain a construction list of the construction object generated based on the construction solution.
